# EUROPEAN PATENT APPLICATION

(11) **EP 2 448 027 A1**
(43) Date of publication of application: **02.05.2012**
(21) Application number: 10792142.1
(22) Date of filing: 23.06.2010
(51) Int. Cl.: H01L 33/62, H01L 33/60

(54) **LEAD FRAME FOR OPTICAL SEMICONDUCTOR DEVICE, PROCESS FOR MANUFACTURING LEAD FRAME FOR OPTICAL SEMICONDUCTOR DEVICE, AND OPTICAL SEMICONDUCTOR DEVICE**

(30) Priority: 24.06.2009 JP 2009150082
(71) Applicant: Furukawa Electric Co., Ltd., Chiyoda-ku Tokyo 100-8322 (JP)
(72) Inventor: KOBAYASHI, Yoshiaki, Tokyo 100-8322 (JP); KIKUCHI, Shin, Tokyo 100-8322 (JP)
(74) Representative: Forstmeyer, Dietmar
(86) International application number: PCT/JP2010/060671
(87) International publication number: WO 2010/150824

(57) **Abstract**

A lead frame for an optical semiconductor device, having a reflection layer (2) composed of silver or a silver alloy formed on an outermost surface of an electrically-conductive substrate (1), in which a thickness of the reflection layer is from 0.2 to 5.0 µm, and in which an intensity ratio of a (200) plane is 20% or more to the total count number when the silver or the silver alloy of the reflection layer is measured by an X-ray diffraction method; a method of producing the same; and an optical semiconductor device utilizing the same.

## Description

### TECHNICAL FIELD

The present invention relates to a lead frame for an optical semiconductor device, a method of producing the same, and an optical semiconductor device.

### BACKGROUND ART

Lead frames for optical semiconductor devices have been widely used in, for example, constitution parts of light sources for various display and lighting, in which light-emitting elements of optical semiconductor elements, such as LEDs (light-emitting diodes), are utilized as the light sources. Such an optical semiconductor device is produced by, for example, arranging a lead frame on a substrate, mounting a light-emitting device on the lead frame, and sealing the light-emitting device and its surrounding with a resin, to prevent deterioration of the light-emitting device and its surrounded region by external factors, such as heat, humidity, and oxidization.

When a LED is used as a light source for lighting, there is a damand for reflective materials for lead frames to have a high reflectance (e.g. reflectance 80% or more) in the whole regions of visible light wavelength (400 to 700 nm). Further, LEDs have been recently used as light sources for measurement/analytical equipments using ultraviolet rays, and there is a demand for the reflective materials to have a high reflectance in a near-ultraviolet region (wavelength of 340 to 400nm). Thus, in the optical semiconductor devices to be used as light sources for lighting or the light sources for measurement/analytical equipments, the reflection property of reflective materials is a very important factor upon which product performance depends.

The methods of realizing an LED for emitting white light are classified mainly into three kinds: a method of arranging three chips for emitting all lights of red (R), green (G), and blue (B) colors; a method of using a sealing resin prepared by dispersing a yellow luminescent material in a blue-color LED chip; and a method of using a sealing resin prepared by dispersing R, G, and B luminescent materials in an LED chip in the near-ultraviolet region. Conventionally, the method of using a sealing resin prepared by dispersing a yellow luminescent material in a blue-color chip has been mainly utilized. However, because of a problem in a color rendering property, a method of using an LED chip including the near-ultraviolet region in a light-emitting wavelength band has been recently attracting attention.

Responding to such a demand, for the purpose of improvement in the light reflectance (hereinafter referred to as reflectance), particularly in a visible light region, in many cases, a layer (coating) composed of silver or a silver alloy is formed on the lead frame on which a LED element is mounted. The silver coating is known for its high reflectance in a visible light region. Specifically, conventionally known techniques include: forming a silver-plating layer on a reflection plane (Patent Literature 1); and forming a silver or silver alloy layer, followed by subjecting the layer to a heat treatment at 200°C or higher for 30 sec or longer, to give a grain diameter in the resultant layer of 0.5 µm to 30 µm (Patent Literature 2).

### CITATION LIST

### PATENT LITERATURES

Patent Literature 1: JP-A-61-148883 ("JP-A" means unexamined published Japanese patent application)
Patent Literature 2: JP-A-2008-016674

### SUMMARY OF INVENTION

### TECHNICAL PROBLEM

However, it is found that when a coating of silver or its alloy is simply formed, as in Patent Literature 1, a lowering in reflectance, particularly in the near-ultraviolet region (wavelength 340 to 400 nm) is conspicuously, and the lowering in the reflectance from the vicinity of about 400 nm of the visible light region to the vicinity of 300 nm of the near-ultraviolet region cannot be avoidable.

Further, it is found that if the grain diameter of a coating of silver or a silver alloy is made to be from 0.5 to 30 µm as in Patent Literature 2, the reflectance in the visible light region is good, however, the effect of improvement of the reflectance in the near-ultraviolet region (340 to 400 nm) may not be obtained. Although the detail of that is unclear, the effect of improvement of the reflectance is not observed by only the adjustment of the grain diameter. Thus, it is considered that another characteristics different from the grain diameter would contribute to the improvement of the reflectance. Alternatively, when adjusted to the grain diameter by heat treatment, the silver is oxidized by the influence of remaining oxygen, to lower the reflectance contrary to the above-mentioned case, which results in that a sufficient effect of improvement of the reflectance may not be obtained.

Furthermore, Patent Literature 2 describes that, as the surface roughness of the underlayer, a maximum height Ry, as stipulated in Japanese Industrial Standards (JIS B 0601), is 0.5 µm or more. In plating, the roughness of the underlayer largely affects the roughness of the outermost surface. If the surface roughness (maximum height) Ry of the underlayer is 0.5 µm or more, the surface roughness (maximum height) of the silver or silver alloy which is the coating on the surface of the underlayer is particularly apt to be 0.5 µm or more. In that case, in order to cover the concavo-convex portion completely by plating, some measures for making the coating thicker is necessary, thereby causing a lowering in mass productivity and an increased cost. With respect to the reflection of light, the roughness of a reflection layer largely affects the regular reflection and diffuse reflection. On the other hand, an important point for the optical characteristics of the lead frames for optical semiconductor devices is that even if the roughness of an underlayer is specified, because of the surface roughness of the reflection layer, the optical characteristics of the reflection layer cannot be necessarily specified.

In recent years, LEDs have been positively employed for the lighting application, and the directional property of light becomes important. When the surface roughness of the reflection layer is not suitable, a bias occurs in the directional property. Consequently, a proper control of the directional property has been desired in, particularly lighting application. However, in the technical contents of Patent Literatures 1 and 2, any technique to meet the demand is not disclosed.

The present invention is contemplated for providing a lead frame for an optical semiconductor device which has a favorable reflectance in the near-ultraviolet region (wavelength 340 to 400 nm) and has an appropriately adjusted diffuse reflectance, thereby realizing favorable directional characteristics of light for light sources particularly in lighting application and measurement/analysis application including the near-ultraviolet region, in the lead frames for optical semiconductor devices, which can be used, for example, in LEDs, photocouplers, or photointerrupters. The present invention is also contemplated for providing a method of producing the lead frame for an optical semiconductor device.

### SOLUTION TO PROBLEM

The inventors of the present invention, having studied keenly the above-described problems, found that a lead frame for an optical semiconductor device excellent in the light reflectance in the near-ultraviolet region of wavelength 340 to 400 nm can be obtained, by making the lead frame for an optical semiconductor device to have a reflection layer composed of silver or a silver alloy formed on an outermost surface of an electrically-conductive substrate, in which a layer thickness of the outermost layer is from 0.2 to 5.0 µm, and in which an intensity ratio of a (200) plane is 20% or more to the total count number when the silver or the silver alloy of the reflection layer is measured by an X-ray diffraction method. The inventors attained the present invention based on this finding. Further, taking a balance in the directional property of light into consideration, the inventors found that the lead frame having a favorable balance in directional characteristics, particularly in lighting application, can be obtained, by setting the surface roughness, i.e. an arithmetic average height Ra, of the reflection layer to 0.05 to 0.30 µm. The inventors attained the present invention based on this finding.

That is, according to the present invention, there is provided the following means:
(1) A lead frame for an optical semiconductor device, comprising a reflection layer composed of silver or a silver alloy formed on an outermost surface of an electrically-conductive substrate, wherein a thickness of the reflection layer is from 0.2 to 5.0 µm, and wherein an intensity ratio of a (200) plane is 20% or more to the total count number when the silver or the silver alloy of the reflection layer is measured by an X-ray diffraction method.
(2) The lead frame for an optical semiconductor device according to item (1), wherein a surface roughness of the reflection layer in an arithmetic average height Ra is from 0.05 to 0.30 µm.
(3) The lead frame for an optical semiconductor device according to item (1) or (2), wherein the electrically-conductive substrate is composed of copper, a copper alloy, iron, an iron alloy, aluminum, or an aluminum alloy.
(4) The lead frame for an optical semiconductor device according to item (3), wherein an electrical conductivity of the electrically-conductive substrate is 10% or more in IACS (International Annealed Copper Standard).
(5) The lead frame for an optical semiconductor device according to any one of items (1) to (4), wherein the silver or silver alloy forming the reflection layer is composed of a material selected from the group consisting of silver, a silver-tin alloy, a silver-indium alloy, a silver-rhodium alloy, a silver-ruthenium alloy, a silver-gold alloy, a silver-palladium alloy, a silver-nickel alloy, a silver-selenium alloy, a silver-antimony alloy, and a silver-platinum alloy.
(6) The lead frame for an optical semiconductor device according to any one of items (1) to (5), further comprising at least one intermediate layer composed of a metal or alloy selected from the group consisting of nickel, a nickel alloy, cobalt, a cobalt alloy, copper, and a copper alloy, formed between the electrically-conductive substrate and the reflection layer.
(7) The lead frame for an optical semiconductor device according to item (6), wherein the total thickness of the intermediate layer is from 0.2 to 2.0 µm.
(8) A method of producing the lead frame for an optical semiconductor device according to any one of items (1) to (7), comprising: forming at least the reflection layer by electroplating.
(9) The method of producing the lead frame for an optical semiconductor device according to item (8), wherein a current density when forming the reflection layer by the electroplating is from 0.005 to 1 A/dm².
(10) An optical semiconductor device comprising: the lead frame for an optical semiconductor device according to any one of items (1) to (7); and an optical semiconductor element, wherein the reflection layer is provided on a portion where at least the optical semiconductor element is mounted.

### ADVANTAGEOUS EFFECTS OF INVENTION

According to the lead frame for an optical semiconductor device of the present invention, by forming the reflection layer composed of silver or a silver alloy to have a thickness of 0.2 to 5.0 µm, and by making the intensity ratio of the (200) plane in the reflection layer measured by the X-ray diffraction method to be 20% or more to the total count number, the reflectance at 340 to 400 nm in the near-ultraviolet region is improved and a good reflectance is obtained in an LED mounted as an optical semiconductor chip in particular including a light-emitting wavelength of the near-ultraviolet region. Further, a lead frame having a good balance in directional characteristics, particularly in lighting application is obtained, by setting the surface roughness Ra of the reflection layer to preferably 0.05 to 0.30 µm. That is, the present invention can provide the lead frame for an optical semiconductor device which is favorable in the reflection property over a wide range from the near-ultraviolet region to the visible light region, and also excellent in the directional characteristics in lighting application and measurement/analysis application including the near-ultraviolet region.
Other and further features and advantages of the invention will appear more fully from the following description, appropriately referring to the accompanying drawings.

### BRIEF DESCRIPTION OF DRAWINGS

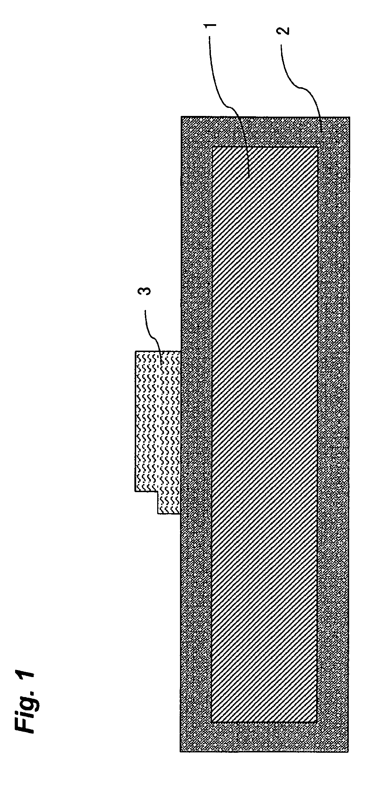

{Fig. 1}
   Fig. 1 is a cross-sectional view schematically illustrating a first embodiment of the lead frame for an optical semiconductor device according to the present invention.
{Fig. 2}
   Fig. 2 is a cross-sectional view schematically illustrating a second embodiment of the lead frame for an optical semiconductor device according to the present invention.
{Fig. 3}
   Fig. 3 is a cross-sectional view schematically illustrating a third embodiment of the lead frame for an optical semiconductor device according to the present invention.
{Fig. 4}
   Fig. 4 is a cross-sectional view schematically illustrating a fourth embodiment of the lead frame for an optical semiconductor device according to the present invention.
{Fig. 5}
   Fig. 5 is a cross-sectional view schematically illustrating a fifth embodiment of the lead frame for an optical semiconductor device according to the present invention.
{Fig. 6}
   Fig. 6 is a cross-sectional view schematically illustrating a sixth embodiment of the lead frame for an optical semiconductor device according to the present invention.
{Fig. 7}
   Fig. 7 is a cross-sectional view schematically illustrating the arithmetic average height Ra in the embodiments of the lead frame for an optical semiconductor device according to the present invention.

### DESCRIPTION OF EMBODIMENTS

The lead frame of the present invention has the reflection layer composed of silver or a silver alloy on the outermost surface on the electrically-conductive substrate, wherein the thickness of the reflection layer is from 0.2 to 5.0 µm, and wherein the intensity ratio of the (200) plane is 20% or more to the total count number, when measuring the silver or silver alloy of the reflection layer by an X-ray diffraction method, based on the "X-ray diffraction analysis general rules" as stipulated under JIS K 0131 in Japanese Industrial Standards. Such a specific structure allows the reflectance in the near-ultraviolet region (wavelength 340 to 400 nm) to be sufficiently improved, which gives a favorable reflectance in the LED mounted as the optical semiconductor chip in particular whose light-emitting wavelength includes a wavelength in the near-ultraviolet region. When the orientation of the (200) plane is less than 20%, the orientation of the (111) plane is preferentially strengthened. As a result, the reflectance at wavelength 340 to 400 nm becomes less than 60% and the characteristics becomes poor. In this regard, the term "total count number" means all the numbers counted when measured by the thin-film method in the X-ray diffraction method. Herein, when a percentage of the count number of the (200) plane is calculated, the value is obtained by calculating by the equation: {the count number of the (200) plane}/(all the count numbers) x 100 (%). The upper limit of the orientation of the (200) plane is not particularly limited, and the maximum value is about 40%, for example, when forming by electroplating.

In the lead frame for an optical semiconductor device of the present invention, the thickness of the reflection layer composed of silver or a silver alloy which is 0.2 µm or more is the minimum thickness required to adjust the intensity ratio of the (200) plane without any affection by the orientation of the lower layer, for example, when forming by electroplating. Accordingly, a stable reflectance with high reliability is obtained and long-term reliability can be ensured. On the other hand, when the thickness of the reflection layer is 5.0 µm or less, cost reduction can be achieved without using noble metals more than necessary, and thus an environment-friendly lead frame can be provided. Further, this is also because that an effect of the long-term reliability is saturated when the thickness of the reflection layer is more than 5.0 µm.

With respect to the surface roughness of the outermost surface of the reflection layer, good directional characteristics for using in lighting application or measurement/analysis application can be achieved, by controlling the arithmetic average height Ra, as stipulated in Japanese Industrial Standards (JIS B 0601:2001), to 0.05 to 0.30 µm, which allows to light up a large area uniformly. This is because, the ratio of the diffuse reflectance to the total reflectance is controlled by controlling the Ra, which enables the directional balance, particularly in lighting application to be good. When the Ra is too small, the regular reflection component becomes too strong. Thus, when the LED is mounted on the reflection layer, it is difficult to illuminate the whole layer uniformly. On the other hand, when the Ra is too large, the quantity of light which can be taken out is reduced because the diffuse reflection component is strong. Thus, the efficiency as lighting becomes poor. The Ra is preferably from 0.10 to 0.25 µm, more preferably from 0.10 to 0.15 µm. As a result, the ratio of the diffuse reflectance to the total reflectance is adjusted to 45 to 85% in wavelength 340 to 400 nm, and thus good directional characteristics for illumination application are obtained.

Further, by forming the substrate with copper, a copper alloy, iron, an iron alloy, aluminum, or an aluminum alloy, the lead frame for an optical semiconductor device of the present invention can be made to have a favorable reflectance property, forming of the layers on the surface thereof can be conducted readily, and the lead frame which can contribute to a lowered production cost can be obtained. Further, the lead frame whose substrate is formed with any one of those metals, is excellent in the heat releasing property (heat dissipation), this is because the generated heat (thermal energy) that is generated upon emission by the light-emitting body can be released or dissipated smoothly to the outside via the lead frame. Based on those, the long service life of the light-emitting device and the long-term stability of the reflectance property can be expected. This is dependant on the electrical conductivity of the substrate under IACS (International Annealed Copper Standard), and one having higher electrical conductivity is better in the heat releasing property. Thus, one with the electrical conductivity of at least 10% or more is preferable, and one with the electrical conductivity of 50% or more is more preferable. If the electrical conductivity is a value usually obtained, the upper limit thereof is not particularly limited.

When the silver or silver alloy for forming the reflection layer in the lead frame for an optical semiconductor device of the present invention is composed of a material selected from the group consisting of silver, a silver-tin alloy, a silver-indium alloy, a silver-rhodium alloy, a silver-ruthenium alloy, a silver-gold alloy, a silver-palladium alloy, a silver-nickel alloy, a silver-selenium alloy, a silver-antimony alloy, and a silver-platinum alloy, the lead frame with favorable reflectance and productivity is obtained.

Further, when the lead frame for an optical semiconductor device of the present invention is provided with at least one intermediate layer composed of a metal or alloy selected from the group consisting of nickel, a nickel alloy, cobalt, a cobalt alloy, copper, and a copper alloy, between the electrically-conductive substrate and the reflection layer composed of silver or a silver alloy, it is possible to prevent deterioration of the reflectance property caused by diffusion of the material for forming the electrically-conductive substrate to the reflection layer due to heat generated when the light-emitting device emits light; the reflectance property becomes highly reliable over a long period of time; and the adhesion property between the substrate and the reflection layer composed of silver or a silver alloy is also improved. The thickness of the intermediate layer can be determined, taking the pressing property, the production costs, the productivity, the heat resistance, and the like, into consideration. Under the general conditions, the total thickness of the intermediate layers is preferably 0.2 to 2.0 µm, and more preferably 0.5 to 2.0 µm. The intermediate layer may be formed of a plurality of layers, but, in general, the number of intermediate layers is preferably 2 or less, taking the productivity into consideration. In the case of forming 2 or more of the intermediate layers, when the layers are formed of the above-mentioned metal or alloy (constitution materials of the intermediate layer), and the total thickness is set within the above-mentioned range, the layers may be formed of the same material or different materials with each other, and the thickness of the respective layer may be the same as or different from each other.

It is preferable that the lead frame for an optical semiconductor device of the present invention is formed by electroplating. Examples of other forming methods include cladding and sputtering, but the control of the thickness is difficult when using these other methods and the production costs become high. As the production method of appropriately controlling the thickness in micrometer order, electroplating is excellent.

With respect to the method of producing the lead frame for an optical semiconductor device of the present invention, when the reflection layer composed of silver or a silver alloy is formed by electroplating, the plating current density is preferably from 0.005 to 1.0 A/dm². This is because when the layer is produced at the current density within the range of 1.0 A/dm² or less, the orientation of the (200) plane of the reflection layer can be readily adjusted to 20% or more to the total count number, and the surface roughness can be adjusted to an appropriate range. When the current density is higher than the range, the silver or silver alloy of the reflection layer is preferentially oriented to the (111) plane, which causes a lowering in the reflectance in the near-ultraviolet region (wavelength 340 to 400 nm). From the viewpoint of productivity, the reflection layer is produced preferably at the current density of 0.05 to 1.0A/dm², more preferably 0.05 to 0.5 A/dm².

When the reflection layer is produced at the current density, the deposition speed becomes very slow. Thus, it is necessary to adjust the treatment time and the length of the plating tank, in order to obtain a required plating thickness. Additionally, the target orientation is also obtained by, for example, forming a portion in a depth up to at least 0.2 µm or more from the outermost surface of the reflection layer at the current density, and thus the reflectance is improved. This because the thickness of 0.2 µm or more from the outermost surface which is formed at the current density is a minimum thickness required to adjust the intensity ratio of the (200) plane, without any affection by the orientation of the lower layer. If the thickness from the outermost surface which is formed at the current density is too thin, it is affected by the orientation of the intermediate layer formed on the lower layer or the lower layer of the reflection layer. Accordingly, a possibility that the reflectance in the near-ultraviolet region (340 to 400 nm) will be less than 60% becomes higher.

Further, in the optical semiconductor device of the present invention, the lead frame of the present invention is used for the portion on which at least an optical semiconductor element is mounted, and thus the favorable reflectance property can be efficiently obtained at a low cost. This is because the effect of the reflection property is sufficiently improved, by forming the reflection layer composed of silver or a silver alloy at only the portion on which the optical semiconductor element is mounted. In this case, the reflection layer composed of silver or a silver alloy may be partially formed, and it may be formed by partial plating, such as stripe plating or spot plating. Production of the lead frame with the thus-partially-formed reflection layer makes it possible to cut the amount of metal to be used at a portion where the reflection layer is not formed, and thus the resultant optical semiconductor device can be friendly to the environment and can achieve reduction of the production costs.

Hereinafter, embodiments of the lead frame for an optical semiconductor device of the present invention will be described, using the drawings. Each of the drawings shows a state that the optical semiconductor element is mounted on the lead frame. The respective embodiment is an example, and the scope of the present invention is not limited to those embodiments.

Fig. 1 is a cross-sectional view schematically illustrating the first embodiment of the lead frame for an optical semiconductor device according to the present invention. In the lead frame of this embodiment, a reflection layer 2 composed of silver or a silver alloy is formed on an electrically-conductive substrate 1, and an optical semiconductor element 3 is mounted on a portion of the surface of the reflection layer 2. In the present invention, the lead frame of this embodiment has the intensity ratio of the (200) plane of the reflection layer 2 measured by the X-ray diffraction method to be 20% or more to the total count number, and it is a lead frame for an optical semiconductor device excellent in the reflection property in the near-ultraviolet to visible light region. More preferably, the surface roughness in terms of the arithmetic average height Ra of the reflection layer 2 is from 0.05 to 0.30 µm, and the resultant lead frame for an optical semiconductor device is excellent in the balance of directional characteristics of light.

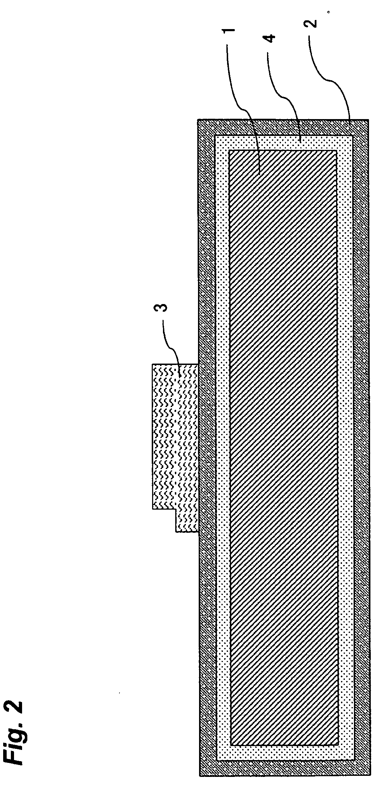

Fig. 2 is a cross-sectional view schematically illustrating the second embodiment of the lead frame for an optical semiconductor device according to the present invention. A difference between the lead frame of the embodiment shown in Fig. 2 and the lead frame shown in Fig. 1 is that an intermediate layer 4 is formed between the electrically-conductive substrate 1 and the respective reflection layer 2. Other points are the same as those of the lead frame shown in Fig. 1.

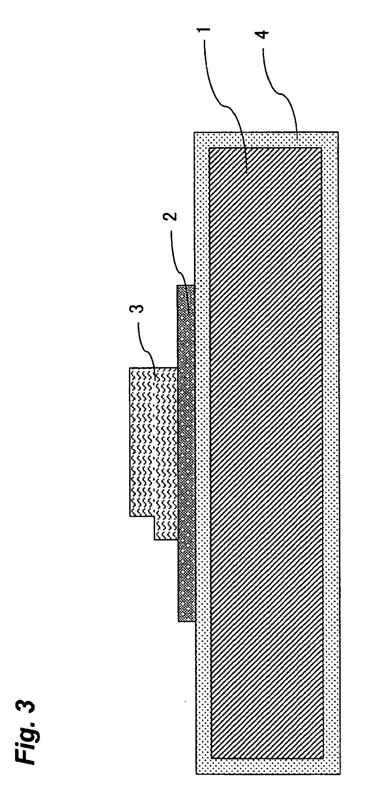

Fig. 3 is a cross-sectional view schematically illustrating the third embodiment of the lead frame for an optical semiconductor device according to the present invention. In the lead frame shown in Fig. 3, the reflection layer 2 is formed at a portion on which the optical semiconductor element 3 is mounted and the vicinity of the portion. Remaining regions other than that portion do not contribute to the refraction of light, and are portions to be coated with, for example, a mold resin. In the present invention, it is thus possible to form the reflection layer 2 composed of silver or a silver alloy only at the portion contributing to the reflection of light.
In this embodiment, the intermediate layer 4 is formed on the entire surface of the electrically-conductive substrate 1. However, as long as the intermediate layer has a form of being present between the electrically-conductive substrate 1 and the reflection layer 2, it may be partially formed.

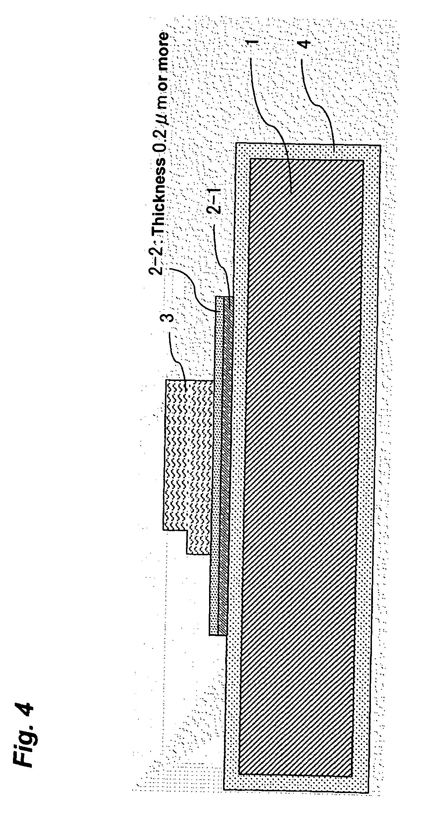

Fig. 4 is a cross-sectional view schematically illustrating the fourth embodiment of the lead frame for an optical semiconductor device according to the present invention. In the lead frame shown in Fig. 4, similarly to that of Fig. 3, the reflection layer 2 is formed at only the portion on which the optical semiconductor element 3 is mounted and the vicinity of the portion, but the reflection layer 2 has a two-layer structure of a lower layer 2-1 and an upper layer (surface layer) 2-2. Herein, the upper layer 2-2 of the reflection layer is the layer formed whose intensity ratio of the (200) plane is 20% or more to the total count number and whose thickness is at least 0.2 µm or more. Thus, for example, when the reflection layer 2 is formed by electroplating, the first layer (lower layer) 2-1 of the reflection layer may be formed at a relatively high current density in a usual manner, for example, at 1.5 A/dm², and then the second layer (upper layer) 2-2 of the reflection layer whose depth be at least 0.2 µm or more from the surface of the reflection layer may be formed at a plating current density of 0.005 to 1.0 A/dm² so as to readily adjust the intensity ratio of the (200) plane to be 20% or more to the total count number. Thus, when the reflection layer having two layers of upper and lower layers is formed while changing the current density in plating, it is possible to shorten the production time period, as compared with the case where the whole thickness of the reflection layer is formed at 0.005 to 1.0 A/dm². Therefore, this manner is effective.

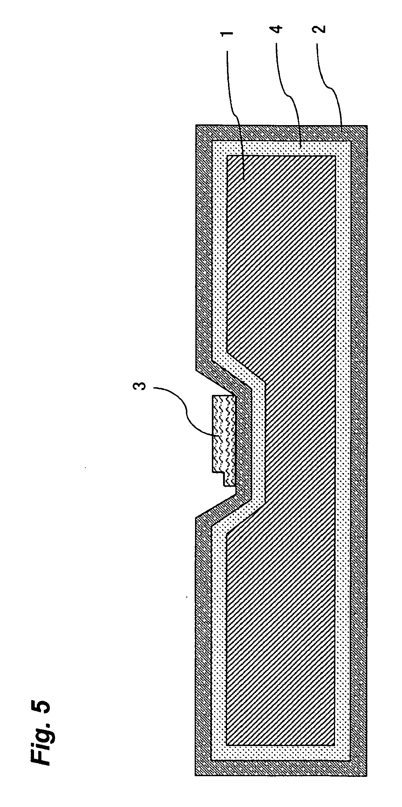

Fig. 5 is a cross-sectional view schematically illustrating the fifth embodiment of the lead frame for an optical semiconductor device according to the present invention, in which a recess is provided on the electrically-conductive substrate 1 and the optical semiconductor element 3 is mounted at the inside of the recess. As in this embodiment, the lead frame for an optical semiconductor device of the present invention can also be applied to such a shape of lead frame that the recess is provided to improve the light-concentrating property.

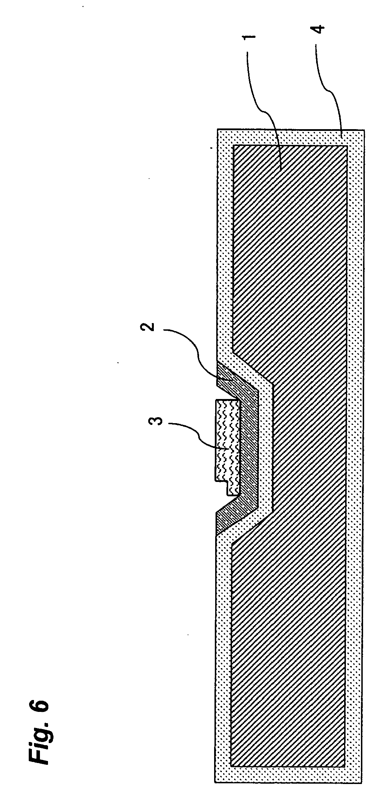

Fig. 6 is a cross-sectional view schematically illustrating the sixth embodiment of the lead frame for an optical semiconductor device according to the present invention, in which a recess is provided on the electrically-conductive substrate 1, the optical semiconductor element 3 is mounted at the inside of the recess, and the reflection layer 2 is formed only at the recess. In this way, in the lead frame having a recess, the reflection layer 2 may be provided only at the portion contributing to the reflection of light to be emitted by the optical semiconductor element.

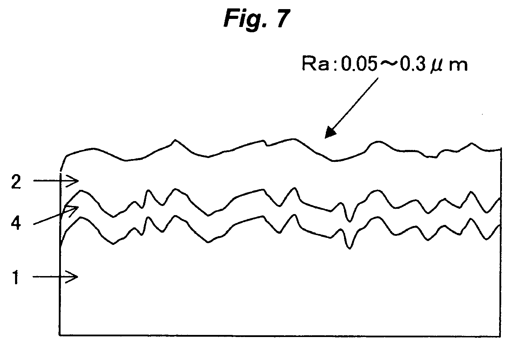

Fig. 7 is a cross-sectional view schematically illustrating the arithmetic average height Ra in the embodiments of the lead frame for an optical semiconductor device according to the present invention. Fig. 7 shows a state that the arithmetic average height Ra of the reflection layer 2 is from 0.05 to 0.30 µm, in the lead frame provided with the electrically-conductive substrate 1, the intermediate layer 4, and the reflection layer 2. Thus, the ratio of the diffuse reflectance to the total reflectance is controlled by controlling Ra, and thus the above excellent effects can be obtained, and the directional balance, particularly in lighting application, becomes more favorable. As the method of controlling the Ra, in addition to the method of adjusting the current density, the Ra value can be properly controlled, by adjusting any length of the treatment time period given to plating treatment or by adjusting the type and content of additives in plating liquid components. For example, the optimal concentration or current density varies depending on the type of the additives to be used in a plating liquid. As a control means for that, the reflection layer having a larger Ra value as the surface roughness can be obtained, by decreasing the concentration of the additive or increasing the current density. On the other hand, for example, the reflection layer having a smaller Ra value as the surface roughness can be obtained, by increasing the concentration of the additive or decreasing the current density.

As the method of producing the lead frame for an optical semiconductor device of the present invention, an arbitrary method can be used. It is preferable that the reflection layer 2 composed of silver or a silver alloy (even a single layer or the respective layer of a plurality of layers) and the intermediate layer 4 are formed by electroplating, respectively.

### EXAMPLES

### (Example No. 1)

In Example No. 1, the respective electrically-conductive substrate, as shown in Table 1, with thickness 0.3 mm and width 50 mm, was subjected to the following pretreatments, and then the following electroplating, thereby to obtain the respective lead frame of Examples 1 to 25 according to the present invention (Ex.), Reference example 1 (Ref. ex.), Conventional example 1 (Conv. ex.), and Comparative example 1 (Comp. ex.), having the respective structure as shown in Table 1. The silver strike plating was conducted to thickness 0.01 µm, before forming the reflection layer.
Herein, out of materials used as the electrically-conductive substrates, "C19400 (a Cu-Fe-based alloy material: Cu-2.3Fe-0.03P-0.15Zn)", "C52100 (phosphor bronze: Cu-8Sn-P)", "C26000 (brass: Cu-30Zn)", and "C72500 (a Cu-Ni-Sn-based alloy material: Cu-9Ni-2.4Sn)" represent copper alloy substrates, and the numerical values following 'C' indicate types based on CDA (Copper Development Association) standards. The unit of the value of each element is based on mass%.
Further, "A1100", "A2014", "A3003", and "A5052" represent aluminum or aluminum alloy substrates. The ingredients thereof are stipulated in Japanese Industrial Standards (e.g., JIS H 4000:2006).
Furthermore, "SPCC" and "SUS304" represent iron-based substrates, in which "SUS304" represents a stainless steel of the type as stipulated in JIS (JIS G 4305:2005) (an iron-based alloy composed of 18 mass% of chromium, and 8 mass% of nickel, with the balance of iron and inevitable impurities), and "SPCC" represents a cold-rolled steel sheet of the type as stipulated in JIS (JIS G 3141:2009).

### (Pretreatment conditions)

### [Electrolytic degreasing]

Degreasing liquid: NaOH 60 g/L
Degreasing conditions: 2.5 A/dm², temperature 60°C, degreasing time period 60 seconds, cathodic degreasing

### [Acid pickling]

Acid pickle: 10% sulfuric acid
Acid pickling conditions: 30 seconds dipping, room temperature

### [Zincate conversion] Conducted when the substrate was of aluminum

Zincate conversion liquid: NaOH 500 g/L, ZnO 100 g/L, dihydroxysuccinic acid (C₄H₆O₆) 10 g/L, FeCl₂ 2 g/L
Treatment conditions: 30 seconds dipping, room temperature

### [Ag strike plating] Layer thickness 0.01 µm

Plating liquid: KAg(CN)₂ 5 g/L, KCN 60 g/L
Plating conditions: Current density 2 A/dm², plating time period 4 seconds, temperature 25°C

Compositions of plating liquids and plating conditions in each of the plating applied to in Example No. 1 are described below. In Examples 1 to 25 and Comparative example 1 in which the silver plating thickness was thinner than that as stipulated in the present invention, the current density was appropriately adjusted to 0.008 to 1.0 A/dm², to control the orientation. On the other hand, in Conventional example 1, the current density was set to a usual plating condition of 1.5 A/dm². These current density conditions are shown in Table 1.

### (Plating conditions)

### [Ag plating] Reflection layer formation conditions in Examples 1 to 15 and 18 to 25, Reference example 1, and Comparative example 1

Plating liquid: AgCN 50 g/L, KCN 100 g/L, K₂CO₃ 30 g/l
Plating conditions: Current density 0.008 to 1.0 A/dm², temperature 30°C

### [Ag plating] Reflection layer formation conditions in Conventional example 1 Plating liquid: AgCN 50 g/L, KCN 100 g/L, K₂CO₃ 30 g/l

Plating conditions: Current density 1.5 A/dm², temperature 30°C

### [Ag-Sn alloy plating] Reflection layer formation conditions in Example 16

Plating liquid: KCN 100 g/L, NaOH 50 g/L, AgCN 10 g/L, K₂Sn(OH)₆ 80 g/L
Plating conditions: Current density 1 A/dm², temperature 40°C

### [Ag-Pd alloy plating] Reflection layer formation conditions in Example 17

Plating liquid: KAg(CN)₂ 20 g/L,PdCl₂ 25 g/L,K₄O₇P₂ 60 g/L,KSCN 150 g/L
Plating conditions: Current density 0.25 A/dm², temperature 40°C

### [Ni plating] Intermediate layer formation conditions

Plating liquid: Ni(SO₃NH₂)₂•4H₂O 500 g/L, NiCl₂ 30 g/L, H₃BO₃ 30 g/L
Plating conditions: Current density 5 A/dm², temperature 50°C

### [Co plating] Intermediate layer formation conditions

Plating liquid: Co(SO₃NH₂)₂·4H₂O 500 g/L, CoCl₂ 30 g/L, H₃BO₃ 30 g/L
Plating conditions: Current density 5 A/dm², temperature 50°C

### [Cu plating] Intermediate layer formation conditions

Plating liquid: CuSO₄·5H₂O 250 g/L, H₂SO₄ 50 g/L, NaCl 0.1 g/L
Plating conditions: Current density 6 A/dm², temperature 40°C

The intensity ratio of the (200) plane composed of the silver or silver alloy of the reflection layer was determined by the following method of measuring an intensity ratio. That is, in the X-ray diffraction method, the intensity of the (200) plane orientation and the number of the total intensity (the total count number) were measured at a measurement angle of 2θ = 20° to 100° and an X-ray incidence angle of 1°, by the thin-film method using an X-ray-analysis apparatus (RAD-A: manufactured by Rigaku Corporation), and the ratio of the intensity of the (200) plane orientation to the number of the total intensity (the total count number) was calculated, which ratio is defined as the intensity ratio of (200) plane. The results are shown in Table 1.

The samples obtained in this example each had one reflection layer.
The surface roughness of the respective sample was measured, using a contact-type surface roughness meter (trade name: SE-30H, manufactured by Kosaka Laboratory Ltd.), with measurement distance of 4 mm at three arbitrary points, to determine the average value, which showed that the Ra value was from 0.13 to 0.15 µm in all of the samples.

### {Table 1}

**Table 1**

| | Substrate | | Intermediate layer | | Reflection layer | | | |
|---|---|---|---|---|---|---|---|---|
| | Kind | Electrical conductivity (%IACS) | Kind | Layer thickness (µm) | Kind | Layer thickness (µm) | Intensity ratio of (200) plane (%) | Current density (A/dm²) |
| Ex. 1 | C19400 | 65 | --- | --- | Ag | 2.03 | 21 | 1.00 |
| Ex .2 | C19400 | 65 | --- | --- | Ag | 0.21 | 33 | 0.40 |
| Ex. 3 | C19400 | 65 | --- | --- | Ag | 4.50 | 25 | 0.80 |
| Ex. 4 | C19400 | 65 | Ni | 1.12 | Ag | 2.05 | 30 | 0.50 |
| Ex. 5 | C19400 | 65 | Ni | 0.22 | Ag | 2.01 | 30 | 0.50 |
| Ex. 6 | C19400 | 65 | Ni | 0.47 | Ag | 2.05 | 30 | 0.50 |
| Ex. 7 | C19400 | 65 | Co | 0.51 | Ag | 2.18 | 35 | 0.25 |
| Ex. 8 | C19400 | 65 | Cu | 1.80 | Ag | 1.99 | 38 | 0.10 |
| Ex. 9 | C19400 | 65 | Ni | 1.50 | Ag | 2.06 | 42 | 0.008 |
| Ex. 10 | C19400 | 65 | Ni | 1.50 | Ag | 2.00 | 40 | 0.012 |
| Ex. 11 | C19400 | 65 | Ni | 1.48 | Ag | 2.03 | 39 | 0.047 |
| Ex. 12 | C19400 | 65 | Ni | 1.52 | Ag | 2.05 | 38 | 0.053 |
| Ex. 13 | C19400 | 65 | Ni | 1.55 | Ag | 2.04 | 31 | 0.48 |
| Ex. 14 | C19400 | 65 | Ni | 1.47 | Ag | 2.03 | 30 | 0.51 |
| Ex. 15 | C19400 | 65 | Ni | 1.45 | Ag | 2.02 | 22 | 0.95 |
| Ex. 16 | C19400 | 65 | Ni | 1.15 | Ag-Sn | 2.15 | 33 | 0.40 |
| Ex. 17 | C19400 | 65 | Ni | 0.98 | Ag-Pd | 2.06 | 35 | 0.25 |
| Ex. 18 | C521 00 | 13 | Ni | 0.96 | Ag | 1.95 | 33 | 0.40 |
| Ex. 19 | C26000 | 28 | Ni | 1.10 | Ag | 2.10 | 35 | 0.25 |
| Ex. 20 | C72500 | 12 | Ni | 1.05 | Ag | 2.13 | 33 | 0.40 |
| Ex. 21 | A1100 | 59 | Ni | 1.01 | Ag | 2.04 | 34 | 0.35 |
| Ex. 22 | A2014 | 40 | Ni | 1.08 | Ag | 1.96 | 34 | 0.35 |
| Ex. 23 | A3003 | 50 | Ni | 0.99 | Ag | 2.00 | 34 | 0.35 |
| Ex. 24 | A5052 | 35 | Ni | 1.06 | Ag | 1.98 | 33 | 0.40 |
| Ex. 25 | SPCC | 16 | Cu | 1.03 | Ag | 2.03 | 34 | 0.35 |
| Ref. ex. 1 | SUS304 | 2 | Ni | 1.11 | Ag | 1.98 | 34 | 0.35 |
| Conv. ex. 1 | C19400 | 65 | --- | --- | Ag | 2.06 | 15 | 1.5 |
| Comp. ex. 1 | C19400 | 65 | Ni | 1.13 | Ag | 0.15 | 30 | 0.50 |

### (Evaluation method)

The thus-obtained lead frames of Examples according to the present invention, Reference examples, Conventional examples, and Comparative example, as shown in Table 1, were evaluated in the following experiments and criteria. The results are shown in Table 2.

### (1A) Reflectance measurement:

With a spectrophotometer (U-4100 (trade name, manufactured by Hitachi High-Technologies Corporation)), continuous measurement was made on the total reflectance over a wavelength range of 300 nm to 800 nm. Out of the results, the total reflectance (%) at 340 nm and 400 nm are shown in Table 2. Herein, one having a reflectance of 60% or more at 340 nm and one having a reflectance of 70% or more at 400 nm were judged to be suitable as the lead frames for optical semiconductor devices including the near-ultraviolet region.

### (1 B) Heat releasing property (heat conductivity):

When the electrical conductivity of the electrically-conductive substrate was 10% or more under IACS (International Annealed Copper Standard), it is judged to be high in the heat releasing property (heat conductivity) and "good", marked with "o", while when the electrical conductivity was less than 10%, it is judged to be low in the heat releasing property (heat conductivity) and "poor", marked with "x". The results are shown in Table 2. This is because, the electrical conductivity is almost proportional to the heat conductivity, and the electrical conductivity of 10% or more under IACS is determined as favorable in the heat conductivity and high in the heat releasing property.

### (1C) Examination of productivity:

For reference, the time period (minute) for formation of each plating coating thickness was calculated at a current efficiency of 95%, to examine the productivity, and the results are shown in Table 2.

### {Table 2}

**Table 2**

| | Total reflectance (%) | | Heat releasing property | (For reference) Productivity (min) |
|---|---|---|---|---|
| | @340 nm | @400 nm | | |
| Ex. 1 | 63 | 75 | ○ | 3.3 |
| Ex. 2 | 71 | 82 | ○ | 0.9 |
| Ex. 3 | 68 | 78 | ○ | 9.3 |
| Ex. 4 | 69 | 80 | ○ | 6.8 |
| Ex. 5 | 70 | 80 | ○ | 6.6 |
| Ex. 6 | 69 | 80 | ○ | 6.8 |
| Ex. 7 | 73 | 83 | ○ | 14.4 |
| Ex. 8 | 78 | 85 | ○ | 32.8 |
| Ex. 9 | 79 | 89 | ○ | 424.2 |
| Ex. 10 | 78 | 87 | ○ | 274.6 |
| Ex. 11 | 78 | 86 | ○ | 71.1 |
| Ex. 12 | 76 | 85 | ○ | 63.7 |
| Ex. 13 | 70 | 81 | ○ | 7.0 |
| Ex. 14 | 68 | 79 | ○ | 6.6 |
| Ex. 15 | 63 | 75 | ○ | 3.5 |
| Ex. 16 | 61 | 71 | ○ | 8.9 |
| Ex. 17 | 63 | 75 | ○ | 13.6 |
| Ex. 18 | 70 | 81 | ○ | 8.0 |
| Ex. 19 | 72 | 82 | ○ | 13.8 |
| Ex. 20 | 71 | 82 | ○ | 8.8 |
| Ex. 21 | 74 | 84 | ○ | 9.6 |
| Ex. 22 | 72 | 84 | ○ | 9.2 |
| Ex. 23 | 73 | 83 | ○ | 9.4 |
| Ex. 24 | 71 | 81 | ○ | 8.2 |
| Ex. 25 | 72 | 83 | ○ | 9.6 |
| Ref. ex. 1 | 72 | 83 | × | 9.3 |
| Conv. ex. 1 | 54 | 67 | ○ | 2.3 |
| Comp. ex. 1 | 58 | 68 | ○ | 0.5 |

As is apparent from those results, in Comparative example 1 in which the reflection layer was too thin and Conventional example 1 in which the intensity ratio of the (200) plane was too low, no desired reflectance was obtained at 340 nm and 400 nm. On the other hand, in Examples 1 to 25 in which the thickness of the reflection layer was from 0.2 to 5 µm and the intensity ratio of the (200) plane of the reflection layer measured by the X-ray diffraction method was 20% or more to the total count number, the reflectance at wavelength 340 nm and wavelength 400 nm was good, and the acceptance criteria of 60% or more at 340 nm and 70% or more at 400 nm were satisfied. This means that the improvement in the reflectance in the near-ultraviolet region allows the respective sample to be suitably applied for optical semiconductors using those wavelengths. A substrate good in the electrical conductivity is also good in the heat releasing property, and thus heat generated when an LED emits light can be smoothly released to the outside of the optical semiconductor device, resulting in improvement of the long-term reliability.
By producing at the current density of 0.005 to 1.0 A/dm₂, preferably at 0.05 to 1.0 A/dm² from the viewpoint of the productivity, it is found that the ratio of the orientation can be readily controlled, and that this is an effective production means.
In Reference example 1, the electrical conductivity of the substrate was 2% and thus it was not excellent in heat releasing property. However, it is easily assumed that this Reference example 1 can be suitably used for an optical semiconductor device which does not need the heat releasing property for the lead frame for an optical semiconductor device because of the excellent reflectance.
With respect to the examples according to the present invention, a reflectance of 70% or more and a diffuse reflectance of 45 to 85% are maintained in not only the near-ultraviolet region but also the visible light region in all of the examples. They can be suitably used as lead frames for optical semiconductor devices excellently high in the luminance and also excellent in the balance of the direction property.

### (Example No. 2)

In Example No. 2, the electrically-conductive substrate composed of a copper alloy of C19400 with thickness 0.3 mm and width 50 mm was subjected to the pretreatments in the same manner as in Example No. 1, followed by forming underlayers of Ni plating 0.5 µm and silver strike plating 0.01 µm. Then, as the reflection layer, electric silver plating 2.0 µm was formed. Thus, lead frames of Example 26 to 32 and Reference examples 2 and 3 were produced. In order to adjust the surface roughness of the reflection layer, the concentration of the plating liquid additive was changed or the size of the current density in plating was appropriately adjusted. With respect to the lead frames of Reference examples 2 and 3, a respective reflection layer was formed which had a surface roughness value outside of the given surface roughness value as specified in the present invention. In Reference example 2, a reflection layer with a too small Ra value as the surface roughness was obtained, by using the following sodium thiosulfate with a concentration of 5 g/L as an additive, and setting the current density to 0.1 A/dm². In Reference example 3, a reflection layer with a too large Ra value as the surface roughness was obtained, by using the following sodium thiosulfate with a concentration of 0.1 g/L as an additive, and setting the current density to 1 A/dm².

The composition of the plating liquid for electro silver plating is as follows.

### [Ag plating]

Plating liquid: AgCN 50 g/L, KCN 100 g/L, K₂CO₃ 30 g/L, an additive (sodium thiosulfate 0 to 10 g/L)
Plating conditions: Current density 0.01 to 1.0 A/dm², temperature 30°C

### (Evaluation method)

The thus-obtained lead frames of Examples according to the present invention, and Reference examples, were evaluated in the following experiments and criteria. The results are shown in Table 3.

### (2A) Measurement of surface roughness:

The arithmetic average heights Ra at three arbitrary points were measured with a contact-type surface roughness meter (trade name: SE-30H, manufactured by Kosaka Laboratory Ltd.), and the average of thereof are shown in Table 3.

### (2B) Measurement of diffuse reflectance ratio:

The total reflectance and diffuse reflectance in a range of 300 to 800 nm were continuously measured, with a spectrophotometer (trade name: U-4100, manufactured by Hitachi High-Technologies Corporation). Ratios of the diffuse reflectance to the total reflectance (diffuse reflectance ratio: %) at wavelength 340 nm and 400 nm were determined, and the results are shown in Table 3.

### {Table 3}

**Table 3**

| | Intensity ratio of (200) plane | Surface roughness Ra (µm) | Total reflectance (%) | Diffuse reflectance (%) | Diffuse reflectance ratio (%) | Total reflectance (%) | Diffuse reflectance (%) | Diffuse reflectance ratio (%) |
|---|---|---|---|---|---|---|---|---|
| | | | @340nm | @340nm | | @400nm | @400nm | |
| Ex. 26 | 24 | 0.053 | 67 | 34 | 51 | 78 | 37 | 47 |
| Ex. 27 | 25 | 0.09 | 68 | 40 | 59 | 77 | 43 | 56 |
| Ex. 28 | 26 | 0.12 | 68 | 43 | 63 | 78 | 46 | 59 |
| Ex. 29 | 28 | 0.14 | 69 | 45 | 65 | 79 | 48 | 61 |
| Ex. 30 | 26 | 0.16 | 68 | 48 | 71 | 77 | 51 | 66 |
| Ex. 31 | 25 | 0.23 | 67 | 54 | 81 | 77 | 57 | 74 |
| Ex. 32 | 27 | 0.27 | 69 | 58 | 84 | 78 | 61 | 78 |
| Ref. ex. 2 | 27 | 0.045 | 68 | 32 | 47 | 79 | 35 | 44 |
| Ref. ex. 3 | 26 | 0.32 | 68 | 65 | 96 | 78 | 68 | 87 |

As is apparent from those results, when controlling the plating conditions (e.g. the current density) in forming the reflection layer, to adjust the arithmetic surface height Ra of the reflection layer to 0.05 to 0.30 µm, the diffuse reflectance ratio at wavelength 340 and 400 nm was controlled to 45 to 85%, from which it is expected that directional characteristics with good balance can be obtained. As a result, as the LED lead frame to be used in lighting application, a lead frame for an optical semiconductor device excellent in the reflectance in the near-ultraviolet region and good in the directional balance can be provided according to the present invention.
With respect to the examples according to the present invention, a reflectance of 70% or more and a diffuse reflectance of 45 to 85% are maintained in not only the near-ultraviolet region but also the visible light region in all of the examples. They can be suitably used as lead frames for optical semiconductor devices excellently high in the luminance and also excellent in the balance of the direction property.

### (Example No. 3)

In Example No. 3, the electrically-conductive substrate composed of a copper alloy of C19400 with thickness 0.3 mm and width 50 mm was subjected to the pretreatments in the same manner as in Example 13 in Example No. 1 with the same thickness as that of Example 13 in Example No. 1, followed by applying underlayers of Ni plating and silver strike plating. Then, as the reflection layer further, electric silver plating of the first layer was formed with 1.84 µm at 1.5 A/dm². Further, electric silver plating of the second layer was formed with 0.21 µm at 0.49 A/dm². Thus, a lead frame of Example 33 in which the total thickness of the two-layered reflection layer was 2.05 µm was produced. Alternatively, electric silver plating of the first layer was formed with 1.84 µm at 1.5 A/dm². Then, electric silver plating of the second layer was formed with 0.18 µm at 0.49 A/dm². Thus, a lead frame of Comparative example 2 in which the total thickness of the two-layered reflection layer was 2.02 µm was produced. In Comparative example 2, the plating time period in forming the second layer of the reflection layer was shortened, as compared with that of Example 33. Specifically, the plating time period (0.7 minute) when forming the second layer (surface layer) of the reflection layer in Example 33 was changed to 0.6 minute in Comparative example 2. By measuring the surface roughness Ra of the reflection layer in those lead frame samples in the same manner as above, both of the samples had a surface roughness Ra of about 0.15 µm.
The evaluation methods of the intensity ratio of the (200) plane, the total reflectance, the heat releasing property, and the productivity were conducted in the same manner as in Example No. 1. The results are shown in Table 4.

### {Table 4}

**Table 4**

| | Reflection layer | | | | | Total reflectance (%) | | Heat releasing property | (For ref.) Productivity (min) |
|---|---|---|---|---|---|---|---|---|---|
| | Layer thickness (µm) | | Current density (A/dm²) | | Intensity ratio of (200) plane (%) | @340 nm | @400 nm | | |
| | 1st layer | 2nd layer | 1st layer | 2nd layer | | | | | |
| Ex. 13 | 2.04 | - | 0.48 | - | 31 | 70 | 81 | ○ | 7.0 |
| Ex. 33 | 1.84 | 0.21 | 1.5 | 0.49 | 22 | 63 | 75 | ○ | 2.7 |
| Comp. ex. 2 | 1.84 | 0.18 | 1.5 | 0.49 | 18 | 57 | 70 | ○ | 2.6 |

From the results, it is found that, as in Example 33, when the reflection layer is formed with a plurality of layers, by forming the surface layer with a thickness of at least 0.2 µm from the surface within the range of 0.005 to 1.0 A/dm², i.e. at 0.49 A/dm² in Example 33, the intensity ratio of the (200) plane can be increased to 20% or more, while being affected by the first layer of the reflection layer formed to have a lower layer at current density 1.5 A/dm². As a result, the total reflectance at 340 to 400 nm of the near-ultraviolet region can be maintained at 60% or more. With respect to the productivity, it is found that the time period is shortened by about 60 percent than that of Example 13, and the method in Example 33 is effective as a method excellent in the productivity.
On the other hand, in Comparative example 2 in which the thickness of the second layer of the reflection layer was less than 0.2 µm, it is found that it resulted in poor results of the intensity ratio of the (200) plane of less than 20% and the reflectance at 340 nm of 60% or less.
Thus, it is found that, by coating to form the portion within a thickness of at least 0.2 µm or more from the surface of the reflection layer at a given current density of 0.005 to 1.0 A/dm², the orientation intensity ratio of the (200) plane as the whole reflection layer can be effectively improved, based on the surface layer without any affection on the orientation of the lower layer of the two layers of the reflection layer. Thus, this manner is useful as a method of producing a lead frame for an optical semiconductor device excellent in the reflectance and improved in the productivity.
With respect to the examples according to the present invention, a reflectance of 70% or more and a diffuse reflectance of 45 to 85% are maintained in not only the near-ultraviolet region but also the visible light region in all of the examples. They can be suitably used as lead frames for optical semiconductor devices excellently high in the luminance and also excellent in the balance of the direction property.

### REFERENCE SIGNS LIST

- 1: Electrically-conductive substrate
- 2: Reflection layer
- 2-1: Lower layer of reflection layer
- 2-2: Surface layer of reflection layer
- 3: Optical semiconductor element
- 4: Intermediate layer

Having described our invention as related to the present embodiments, it is our intention that the invention not be limited by any of the details of the description, unless otherwise specified, but rather be construed broadly within its spirit and scope as set out in the accompanying claims.

This application claims priority on Patent Application No. 2009-150082 filed in Japan on June 24, 2009, which is entirely herein incorporated by reference.

## Claims

1. A lead frame for an optical semiconductor device, comprising a reflection layer composed of silver or a silver alloy formed on an outermost surface of an electrically-conductive substrate, wherein a thickness of the reflection layer is from 0.2 to 5.0 µm, and wherein an intensity ratio of a (200) plane is 20% or more to the total count number when the silver or the silver alloy of the reflection layer is measured by an X-ray diffraction method.

2. The lead frame for an optical semiconductor device according to claim 1, wherein a surface roughness of the reflection layer in an arithmetic average height Ra is from 0.05 to 0.30 µm.

3. The lead frame for an optical semiconductor device according to claim 1 or 2, wherein the electrically-conductive substrate is composed of copper, a copper alloy, iron, an iron alloy, aluminum, or an aluminum alloy.

4. The lead frame for an optical semiconductor device according to claim 3, wherein an electrical conductivity of the electrically-conductive substrate is 10% or more in IACS (International Annealed Copper Standard).

5. The lead frame for an optical semiconductor device according to any one of claims 1 to 4, wherein the silver or silver alloy forming the reflection layer is composed of a material selected from the group consisting of silver, a silver-tin alloy, a silver-indium alloy, a silver-rhodium alloy, a silver-ruthenium alloy, a silver-gold alloy, a silver-palladium alloy, a silver-nickel alloy, a silver-selenium alloy, a silver-antimony alloy, and a silver-platinum alloy.

6. The lead frame for an optical semiconductor device according to any one of claims 1 to 5, further comprising at least one intermediate layer composed of a metal or alloy selected from the group consisting of nickel, a nickel alloy, cobalt, a cobalt alloy, copper, and a copper alloy, formed between the electrically-conductive substrate and the reflection layer.

7. The lead frame for an optical semiconductor device according to claim 6, wherein the total thickness of the intermediate layer is from 0.2 to 2.0 µm.

8. A method of producing the lead frame for an optical semiconductor device according to any one of claims 1 to 7, comprising: forming at least the reflection layer by electroplating.

9. The method of producing the lead frame for an optical semiconductor device according to claim 8, wherein a current density when forming the reflection layer by the electroplating is from 0.005 to 1 A/dm².

10. An optical semiconductor device comprising: the lead frame for an optical semiconductor device according to any one of claims 1 to 7; and an optical semiconductor element, wherein the reflection layer is provided on a portion where at least the optical semiconductor element is mounted.
